# EUROPÄISCHE PATENTSCHRIFT

(11) **EP 1 488 426 B1**
(45) Veröffentlichungstag und Bekanntmachung des Hinweises auf die Patenterteilung: **26.10.2005**
(21) Anmeldenummer: 03724832.5
(22) Anmeldetag: 11.03.2003
(51) Int. Cl.: G11C 11/16, H01F 41/30, H01F 41/32, H01F 10/32

(54) **VERFAHREN ZUR HERSTELLUNG EINER REFERENZSCHICHT UND MIT EINER DERARTIGEN REFERENZSCHICHT VERSEHENE MRAM-SPEICHERZELLE**
METHOD FOR PRODUCING A REFERENCE LAYER AND AN MRAM MEMORY CELL PROVIDED WITH SAID TYPE OF REFERENCE LAYER
PROCEDE POUR PRODUIRE UNE COUCHE DE REFERENCE ET CELLULE DE MEMOIRE MRAM DOTEE D'UNE TELLE COUCHE DE REFERENCE

(30) Priorität: 28.03.2002 DE 10214159
(43) Veröffentlichungstag der Anmeldung: 22.12.2004
(73) Patentinhaber: Infineon Technologies AG, 81669 München (DE)
(72) Erfinder: KLOSTERMANN, Ulrich, 94227 Zwiesel (DE); RUEHRIG, Manfred, 90542 Eckental (DE)
(74) Vertreter: Müller - Hoffmann & Partner
(86) Internationale Anmeldenummer: PCT/DE2003/000775
(87) Internationale Veröffentlichungsnummer: WO 2003/083873

(56) Entgegenhaltungen:
- EP-A- 1 187 103
- WO-A-00/02006
- US-A- 5 686 838

## Beschreibung

Die Erfindung betrifft ein Verfahren zur Herstellung einer Referenzschicht für MRAM-Speicherzellen und eine MRAM-Speicherzelle, die eine in dieser Weise hergestellte Referenzschicht aufweist.

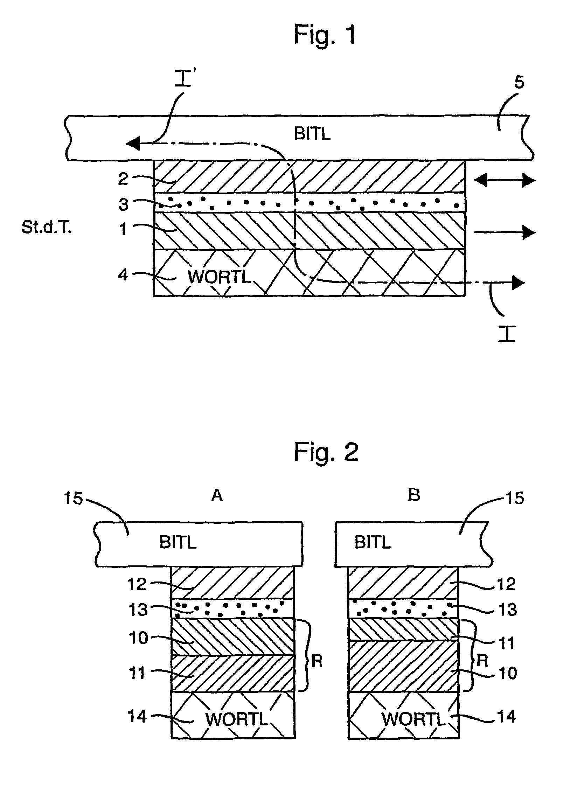

Eine MRAM-Anordnung beruht bekanntlich auf ferromagnetischer Speicherung mit Hilfe des TMR-Effektes (TMR = Tunnel-Magnet-Resistance). Die beiliegende Fig. 1 zeigt einen schematischen Querschnitt durch eine bekannte, diesen TMR-Effekt nutzende MRAM-Speicherzelle. Zwischen einer Bitleitung 5 und einer Wortleitung 4, die sich kreuzen, liegt die TMR-Speicherzelle, die aus einem Schichtstapel mit einer weichmagnetischen Schicht 2, einer Tunneloxidschicht 3 und einer hartmagnetischen oder Referenzschicht besteht. Die Magnetisierungsrichtung (Pfeil) der hartmagnetischen Schicht 1 ist vorgegeben, während die Magnetisierungsrichtung (Doppelpfeil) der weichmagnetischen Schicht 2 einstellbar ist, indem durch die Wortleitung 4 und die Bitleitung 5 entsprechende Ströme I, I' in unterschiedlichen Richtungen geschickt werden. Mit diesen Strömen kann die Magnetisierung der weichmagnetischen Schicht 2 parallel oder antiparallel zur Magnetisierungsrichtung der hartmagnetischen Schicht 1 gepolt werden. Bei paralleler Magnetisierung der beiden Schichten 1 und 2 ist der Widerstandswert des Schichtstapels niedriger als bei antiparalleler Magnetisierung, was als Zustand "0" bzw. "1" oder umgekehrt ausgewertet werden kann.

Da die Nettomagnetisierung der Referenzschicht das Gesamtverhalten der MRAM-Speicherzelle bestimmt, ist es wünschenswert, diese Nettomagnetisierung bei der Herstellung von MRAM-Speicherzellen gezielt einstellbar zu machen.

Es ist demnach Aufgabe der Erfindung, ein Verfahren zur Herstellung einer Referenzschicht für MRAM-Speicherzellen und eine mit einer derart hergestellten Referenzschicht ausgestattete MRAM-Speicherzellen so anzugeben, dass sich die Nettomagnetisierung der Referenzschicht und damit das Gesamtverhalten der MRAM-Speicherzelle gezielt einstellen lässt.

Ein diese Aufgabe lösendes Verfahren zur Herstellung einer Referenzschicht für MRAM-Speicherzellen ist erfindungsgemäß gekennzeichnet durch folgende Schritte:
(A) für die Referenzschicht wird ein Schichtsystem bereitgestellt, das eine durch ein äußeres Magnetfeld dauermagnetisierbare erste Schicht eines Materials mit einer ersten Curietemperatur T_{C}¹ und eine zweite durch antiferromagnetische Kopplung mit der ersten Schicht magnetisierbare Schicht eines Materials mit einer zweiten Curietemperatur T_{C}² aufweist, die deutlich geringer ist als die erste Curietemperatur T_{C}¹;
(B) ein äußeres Magnetfeld wird erzeugt;
(C) das Schichtsystem wird von einer Temperatur oberhalb der ersten Curietemperatur T_{C}¹ unter Einwirkung des äußeren Magnetfelds bis unter die erste Curietemperatur T_{C}¹ abgekühlt, wobei die Feldstärke des äußeren Magnetfelds größer als die Sättigungsfeldstärke der ersten Schicht ist, so dass sich die Magnetisierung der ersten Schicht durch einen Phasenübergang zweiter Ordnung entlang der Feldrichtung des äußeren Magnetfeldes ausrichtet; und
(D) das Schichtsystem wird anschließend unter die zweite Curietemperatur T_{C}² abgekühlt, wobei sich die Magnetisierung der zweiten Schicht aufgrund antiferromagnetischer Kopplung zwischen der ersten und zweiten Schicht und antiparallel zur Magnetisierung der ersten Schicht ausrichtet.

Demnach wird für die Referenzschicht ein, zum Beispiel symmetrischer, künstlicher Antiferromagnet (AAF) vorgeschlagen, der die zwei antiferromagnetisch gekoppelten Schichten aufweist, die sich in ihrer Curietemperatur unterscheiden. Beim Abkühlen von einer Temperatur oberhalb der ersten Curietemperatur T_{C}¹ in einem von außen angelegten Magnetfeld richtet sich die Magnetisierung der ersten Schicht des Schichtsystems durch einen Phasenübergang zweiter Ordnung entlang der Feldrichtung des äußeren Magnetfelds aus, sofern die äußere Feldstärke größer als die Sättigungsfeldstärke für die erste Schicht ist. Bei weiterem Abkühlen bis unterhalb der zweiten Curietemperatur T_{C}² richtet sich die Magnetisierung der zweiten Schicht durch die antiferromagnetische Kopplung zwischen den beiden Schichten antiparallel zur Magnetisierungsrichtung der ersten Schicht aus. Dadurch bilden die beiden Schichten, das heißt die erste und die zweite Schicht einen künstlichen Antiferromagneten (AAF).

Entscheidend ist die Erzeugung der Magnetisierungsverteilung in der zweiten Schicht durch den Phasenübergang zweiter Ordnung bei der niedrigeren Curietemperatur T_{C}² der zweiten Schicht. Die in der ersten Schicht vorhandene Magnetisierungsverteilung wird dabei durch die vorhandene Kopplung (antiparallel) durch antiferromagnetische Kopplung auf die zweite Schicht übertragen.

Sind die Nettomagnetisierungen (Sättigungsfluss = Sättigungsmagnetisierung x Schichtquerschnitt) der ersten und zweiten Schicht jeweils entsprechend gewählt, kann eine Nettomagnetisierung des Schichtsystems von Null eingestellt werden, das heißt dass die Magnetisierung innerhalb des so erzeugten künstlichen Antiferromagneten damit weitgehend stabil gegen äußere Felder sein sollte, solange die magnetische Kopplung zwischen den einzelnen Schichten stark genug ist.

Weiterhin kann die Nettomagnetisierung des Schichtsystems auch gezielt steuerbar eingestellt werden, indem zum Beispiel die Sättigungsmagnetisierung oder der Schichtquerschnitt der zweiten Schicht geringer gewählt ist als die bzw. der der ersten Schicht. Wenn man somit auf den Vorteil eines symmetrischen künstlichen Antiferromagneten verzichtet, bei dem gleicher Sättigungsfluss der beiden Schichten vorliegt, kann man den vorgeschlagenen Schichtaufbau zur Herstellung eines inversen künstlichen Antiferromagneten benutzen. In der TMR-Speicherzelle befindet sich dann die dünnere Schicht in Kontakt mit der Tunnelbarriere. Das bei dem üblichen Aufbau bestehende Problem, dass zurückbleibende 360°-Wände das Signal schwächen, entfällt, da jede Schicht in sich gesättigt ist und deshalb keine 360°-Wände aufweist.

Eine im Schritt (C) erzielte homogene Magnetisierung der ersten Schicht kann auch durch Zwischenschichtkopplung auf die zweite Schicht übertragen werden. Das heißt, dass im Schritt (A) ein Schichtsystem bereitgestellt wird, welches eine sehr dünne Zwischenkopplungsschicht zwischen der ersten und zweiten Schicht aufweist. Dies hat unter anderem den Vorteil, dass bei gesättigter erster Schicht in der zweiten Schicht keine 360°-Wände auftreten.

Für die erste Schicht und die zweite Schicht des vorgeschlagenen Schichtsystems sind insbesondere folgende Materialkombinationen bevorzugt:
(a) Erste Schicht: (Co,Fe,Mn)₈₀(Si,B)₂₀ mit der Curietemperatur T_{C}¹ = 485°C und zweite Schicht: (Co,Fe,Mo)₇₃(Si,B)₂₇ mit der Curietemperatur T_{C}² = 210°C. Mit dieser Materialkombination wird insgesamt ein Weich/Weich-Magnetisierungsverhalten erreicht.
(b) Erste Schicht: (Co,Fe)₈₃(Si,B)₁₇ mit der Curietemperatur T_{C}¹ = 415°C und zweite Schicht: (Ni,Fe)₇₈(Si,B,C)₂₂ mit der Curietemperatur T_{C}² = 260°C. Diese Materialkombination ermöglicht ein magnetostriktives Verhalten des Schichtsystems.
(c) Erste Schicht: Tb₂₀Fe₄₀Co₄₀ mit der Curietemperatur T_{C}¹ = 400°C und zweite Schicht: Tb₂₀Fe₈₀ mit der Curietemperatur T_{C}² = 150°C. Dies ermöglicht ein ferrimagnetisches Verhalten des Schichtsystems.

Materialien der Zwischenschicht können Ruthenium, Kupfer oder Gold sein.

Die magnetische Kopplung zwischen der ersten Schicht und der zweiten Schicht hängt von der Dicke der Zwischenschicht ab, die so gewählt sein muss, dass die antiferromagnetische Kopplung stattfindet.

Eine mit diesem Verfahren hergestellte Referenzschicht und eine mit einer derartigen Referenzschicht ausgestattete MRAM-Speicherzelle weist insbesondere folgende Vorteile auf:
- gezielte Einstellung der Magnetisierungsverteilung in den Einzelschichten;
- verschwindende Nettomagnetisierung bzw. eine durch Wahl der Sättigungsmagnetisierung und der Dicke der ersten und zweiten Schicht steuerbare Nettomagnetisierung des Schichtsystems;
- beim Einfrieren der ersten Schicht ist die Magnetisierung der zweiten Schicht nicht aktiv (oberhalb T_{C}²);
- Übertragung der homogenen Magnetisierung von der ersten Schicht auf die zweite Schicht durch die erwähnte Zwischenschichtkopplung. Dies hat unter anderem den Vorteil, dass bei gesättigter erster Schicht in der zweiten Schicht keine 360°-Wände auftreten sollten;
- verzichtet man auf den Vorteil des symmetrischen künstlichen Antiferromagneten, bei dem ein gleicher Sättigungsfluss der beiden Schichten vorhanden ist, kann man den vorgeschlagenen Schichtaufbau zur Herstellung eines inversen künstlichen Antiferromagneten benutzen. Das bei dem üblichen Aufbau einer MRAM-Speicherzelle bestehende Problem, dass zurückbleibende 360°-Wände das Signal schwächen, entfällt, da jede Schicht in sich gesättigt ist und deshalb keine 360°-Wände aufweist.

Die nachfolgende Beschreibung beschreibt, Bezug nehmend auf die Zeichnung, Ausführungsbeispiele eines erfindungsgemäßen Verfahrens und einer mit einer solchen Referenzschicht ausgestatteten MRAM-Speicherzelle. Die Zeichnungsfiguren zeigen im einzelnen:
- Fig. 1: in einem schematischen Querschnitt die bereits erläuterte bekannte Struktur einer MRAM-Speicherzelle;
- Fig. 2A und 2B: schematische Querschnitte durch ein erstes und ein zweites Ausführungsbeispiel einer eine erfindungsgemäß hergestellte Referenzschicht aufweisenden MRAM-Speicherzelle;
- Fig. 3: in schematischem Querschnitt ein drittes Ausführungsbeispiel einer weiteren mit einer anderen erfindungsgemäßen Referenzschicht ausgestatteten MRAM-Speicherzelle und
- Fig. 4: schematisch ein Diagramm zur Erläuterung des erfindungsgemäßen Verfahrens zur Herstellung der Referenzschicht.

Bei den in Fig. 2A und 2B schematisch veranschaulichten erfindungsgemäßen MRAM-Speicherzellen liegt zwischen einer Wortleitung (WORTL)14 und einer Bitleitung (BITL)15 ein Schichtenstapel bestehend aus zwei Schichten 10 und 11, die ein erfindungsgemäßes Referenzschichtsystem R bilden, einer Tunnelbarriere 13 und einer weichmagnetischen Schicht 12. In Fig. 2A haben die erste Schicht 10 und die zweite Schicht 11 des Schichtsystems R jeweils die gleiche Sättigungsmagnetisierung und den gleichen Schichtquerschnitt, so dass sich eine Nettomagnetisierung des Schichtsystems R zu Null ergibt.

Dagegen weisen in Fig. 2B die erste Schicht 10 und die zweite Schicht 11 des Schichtsystems R der Referenzschicht eine unterschiedliche Nettomagnetisierung auf, indem der Schichtquerschnitt der zweiten Schicht 11 kleiner gewählt ist als der der ersten Schicht 10. Die dünnere zweite Schicht 11 befindet sich im Kontakt mit der Tunnelbarriere 13. Da jede Schicht, das heißt die erste Schicht 10 und die zweite Schicht 11 in sich gesättigt sind und deshalb keine 360°-Wände aufweisen, entfällt das beim bekannten Aufbau einer MRAM-Speicherzelle bestehende Problem, dass zurückbleibende 360°-Wände das Signal schwächen.

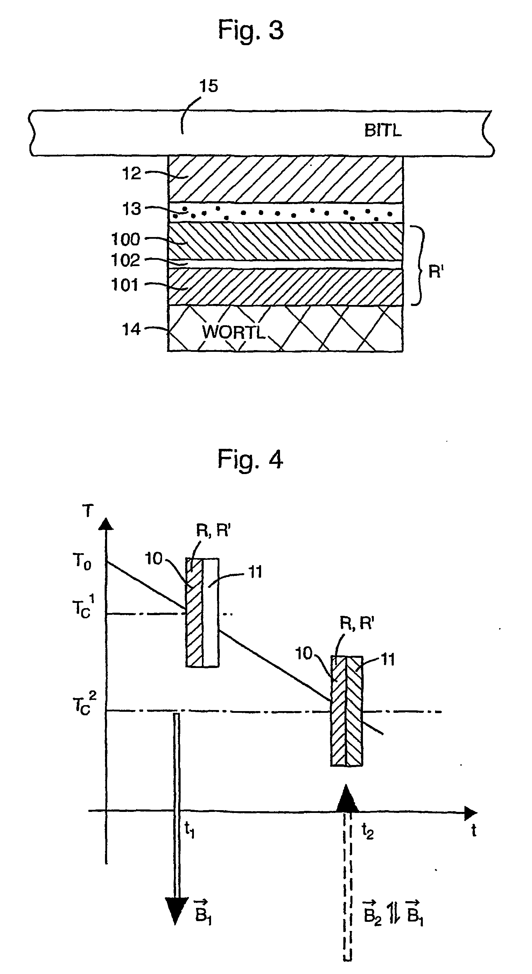

Bei dem in Fig. 3 in Form eines schematischen Querschnitts dargestellten dritten Ausführungsbeispiel hat das Schichtsystem R' der Referenzschicht einen Aufbau aus einer ersten Schicht 100, einer dünnen Zwischenkopplungsschicht 102 und einer zweiten Schicht 101. Durch diese Zwischenkopplungsschicht 102 wird die homogene Magnetisierung der ersten Schicht 100 auf die zweite Schicht 101 durch die Kopplung der Zwischenkopplungsschicht 102 übertragen. Dadurch treten bei gesättigter erster Schicht in der zweiten Schicht keine 360°-Wände auf. Im übrigen hat die in Fig. 3 schematisch dargestellte, dem dritten Ausführungsbeispiel einer erfindungsgemäßen MRAM-Speicherzelle entsprechende Struktur den gleichen Aufbau wie das in Fig. 2A gezeigte erste Ausführungsbeispiel.

In Fig. 4 ist diagrammartig das erfindungsgemäße Verfahren zur Herstellung einer Referenzschicht für MRAM-Speicherzellen veranschaulicht.

Für die Referenzschicht R bzw. R' wird ein Schichtsystem bereitgestellt, das eine durch ein äußeres Magnetfeld magnetisierbare erste Schicht eines Materials mit einer ersten Curietemperatur T_{C}¹ und eine durch antiferromagnetische Kopplung mit der ersten Schicht magnetisierbare zweite Schicht eines Materials mit einer zweiten Curietemperatur T_{C}² aufweist, die deutlich geringer als die erste Curietemperatur T_{C}¹. Die Temperaturachse T zeigt diese beiden Curietemperaturen T_{C}¹ und T_{C}². Zum Zeitpunkt t1 wird das Schichtsystem R, R' von einer Temperatur T0 oberhalb der ersten Curietemperatur T_{C}¹ bis unter die erste Curietemperatur T_{C}¹ abgekühlt, wobei sich dieses Schichtsystem R, R' in einem äußeren Magnetfeld B1 (Pfeil) befindet. Dabei richtet sich die Magnetisierung der ersten Schicht 10 durch einen Phasenübergang zweiter Ordnung entlang der Feldrichtung des äußeren Magnetfelds B1 aus. Voraussetzung dafür ist, dass die Feldstärke von B1 größer als die Sättigungsfeldstärke der ersten Schicht 10 ist.

Bei weiterem Abkühlen kann das Magnetfeld B1 abgeschaltet werden, und sobald zum Zeitpunkt t2 die Temperatur T unter die Curietemperatur T_{C}² der zweiten Schicht 11 sinkt, richtet sich die Magnetisierung der zweiten Schicht 11 durch die antiferromagnetische Kopplung zwischen den beiden Schichten antiparallel zur ersten Schicht 10 aus. Dies bildet den künstlichen Antiferromagneten AAF. Wie erwähnt, und anhand der Fig. 3 beschrieben, kann die antiferromagnetische Kopplung der ersten Schicht auf die zweite Schicht auch durch Vorsehen einer Zwischenkopplungsschicht vermittelt werden.

Wie zum Zeitpunkt t2 in Fig. 4 durch einen gestrichelten Pfeil veranschaulicht, kann zur Homogenisierung der Magnetisierungsverteilung in der zweiten Schicht 11 zusätzlich beim Durchgang durch T_{C}² ein Magnetfeld B2 angelegt werden, dessen Feldrichtung entgegengesetzt zur Magnetisierung der ersten Schicht 10 ist, solange dies nicht zu einer Ummagnetisierung der in der ersten Schicht 10 eingeprägten Magnetisierung ausreicht. Dafür ist eine ausreichende Koerzitiv-Feldstärke der ersten Schicht bzw. ein ausreichend "rechteckiges" Schaltverhalten der ersten Schicht 10 notwendig. Um dies zu erreichen, kann die Stabilität der Magnetisierung der ersten Schicht 10 über eine Kopplung zu einem natürlichen Antiferromagneten stabilisiert werden, dessen Neel-Temperatur oberhalb der zweiten niedrigeren Curietemperatur T_{C}² liegt.

Mögliche Schichtkombinationen für die erste Schicht und die zweite Schicht können sein

| Erste Schicht 10 (100) | T_{C}¹ | Zweite Schicht 11 (101) | T_{C}² | Besonderheit |
|---|---|---|---|---|
| (Co, Fe, Mn)₈₀(Si, B)₂₀ | 485°C | (Co, Fe,Mo)₇₃(Si, B)₂₇ | 210°C | (weich/weich) |
| (Co, Fe)₈₃(Si ,B)₁₇ | 415°C | (Ni, Fe)₇₈(Si, B, C)₂₂ | 260°C | (magnetostriktiv) |
| Tb₂₀Fe₄₀Co₄₀ | 400°C | Tb₂₀Fe₈₀ | 150°C | (ferrimagnetisch) |

Die oben erwähnte Zwischenschicht 102, die in Fig. 3 dargestellt ist, kann aus Ruthenium, Kupfer, Gold bestehen.

### Bezugszeichenliste

- 1; R; R': Referenzschicht
- 2; 12: weichmagnetische Schicht
- 3; 13: Tunnelbarriere
- 10; 100: erste Schicht
- 11; 101: zweite Schicht
- 102: Zwischenkopplungsschicht
- 14: Wortleitung
- 15: Bitleitung
- T_{C}¹, T_{C}²: Curietemperaturen
- B1, B2: Magnetfelder
- t1, t2: Zeiten

## Patentansprüche

1. Verfahren zur Herstellung einer Referenzschicht für MRAM-Speicherzellen,
**gekennzeichnet durch** folgende Schritte:
(A) für die Referenzschicht wird ein Schichtsystem bereitgestellt, das eine **durch** ein äußeres Magnetfeld dauermagnetisierbare erste Schicht (10; 100) eines Materials mit einer ersten Curietemperatur (T_{C}¹) und eine zweite **durch** antiferromagnetische Kopplung mit der ersten Schicht magnetisierbare Schicht (11; 101) eines Materials mit einer zweiten Curietemperatur (T_{C}²) aufweist, die deutlich geringer ist als die erste Curietemperatur (T_{C}¹);
(B) ein äußeres Magnetfeld (B1) wird erzeugt;
(C) das Schichtsystem (R; R') wird von einer Temperatur oberhalb der ersten Curietemperatur (T_{C}¹) unter Einwirkung des äußeren Magnetfelds (B1) bis unter die erste Curietemperatur (T_{C}¹) abgekühlt, wobei die Feldstärke des äußeren Magnetfelds (B1) größer als die Sättigungsfeldstärke der ersten Schicht (10; 100) ist, so dass sich die Magnetisierung der ersten Schicht (10; 100) **durch** einen Phasenübergang zweiter Ordnung entlang der Feldrichtung des äußeren Magnetfeldes ausrichtet; und
(D) das Schichtsystem (R, R') wird anschließend unter die zweite Curietemperatur (T_{C}²) abgekühlt, wobei sich die Magnetisierung der zweiten Schicht (11; 101) aufgrund antimagnetischer Kopplung zwischen der ersten und zweiten Schicht (10; 100 und 11; 101) antiparallel zur Magnetisierung der ersten Schicht (10; 100) ausrichtet.

2. Herstellverfahren nach Anspruch 1,
**dadurch gekennzeichnet,**
**dass** die Nettomagnetisierung des Schichtsystems (R; R') durch die Wahl des Sättigungsflusses, insbesondere des Schichtquerschnitts jeweils der ersten und zweiten Schicht (10; 100 und 11; 101) eingestellt wird.

3. Herstellverfahren nach Anspruch 1 oder 2,
**dadurch gekennzeichnet,**
**dass** die Nettomagnetisierung des Schichtsystems (R; R') durch die jeweils gleiche Nettomagnetisierung der ersten Schicht (10; 100) und der zweiten Schicht (11; 101) zu Null eingestellt wird.

4. Herstellverfahren nach Anspruch 1 oder 2,
**dadurch gekennzeichnet,**
**dass** die Nettomagnetisierung des Schichtsystems (R; R') durch Auswahl der zweiten Schicht (11) so dass deren Schichtquerschnitt geringer ist als der der ersten Schicht (10; 100) ungleich Null eingestellt wird.

5. Herstellverfahren nach einem der vorangehenden Ansprüche,
**dadurch gekennzeichnet,**
**dass** im Schritt (D) beim Durchgang durch die zweite Curietemperatur (T_{C}²) ein äußeres Magnetfeld (B2) angelegt wird, dessen Feldrichtung entgegengesetzt zur Magnetisierungsrichtung der ersten Schicht (10; 100) ist.

6. Herstellverfahren nach einem der Ansprüche 1 bis 5,
**dadurch gekennzeichnet,**
**dass** im Schritt (A) ein Schichtsystem (R') bereitgestellt wird, das eine sehr dünne Zwischenkopplungsschicht (102) zwischen der ersten und zweiten Schicht (100 und 101) aufweist und dass die antiferromagnetische Kopplung in Schritt (D) durch die Zwischenkopplungsschicht (102) vermittelt wird.

7. Herstellverfahren nach einem der Ansprüche 1 bis 6,
**dadurch gekennzeichnet,**
**dass** das Material der ersten Schicht (10; 100) gewählt ist aus der Gruppe, die (Co,Fe,Mn)₈₀(Si,B)₂₀); (Co,Fe)₈₃(Si,B)₁₇; Tb₂₀Fe₄₀Co₄₀ aufweist,
und **dass** das Material der zweiten Schicht gewählt ist aus der Gruppe, die
(Co,Fe,Mo)₇₃(Si,B)₂₇; (Ni,Fe)₇₈(Si,B,C)₂₂; Tb₂₀Fe₈₀ aufweist.

8. Herstellverfahren nach Anspruch 7,
**dadurch gekennzeichnet,**
**dass** das Material der Zwischenkopplungsschicht (102) gewählt ist aus der Gruppe, die Ruthenium, Kupfer, Gold aufweist.

9. MRAM-Speicherzelle,
**dadurch gekennzeichnet,**
**dass** sie eine Referenzschicht aufweist, die aus einem Schichtsystem (R; R') besteht; das eine erste Schicht (10; 100) eines Materials mit einer ersten Curietemperatur (T_{C}¹) und eine zweite Schicht (11; 101) eines Materials mit einer zweiten Curietemperatur (T_{C}²) aufweist, die deutlich unter der ersten Curietemperatur(T_{C}¹) liegt, und
**dass** die Referehzschicht durch das in einem der Ansprüche 1 bis 8 beschriebene Verfahren hergestellt ist.

## Claims

1. Method for fabricating a reference layer for MRAM memory cells,
**characterized by** the following steps:
(A) a layer system is provided for the reference layer, which layer system has a first layer (10; 100) of a material having a first Curie temperature (T_{C}¹), which first layer can be permanently magnetized by an external magnetic field, and a second layer (11; 101) of a material having a second Curie temperature (T_{C}²), which is significantly lower than the first Curie temperature (T_{C}¹), which second layer can be magnetized by antiferromagnetic coupling with the first layer;
(B) an external magnetic field (B1) is generated;
(C) the layer system (R; R') is cooled from a temperature above the first Curie temperature (T_{C}¹) to below the first Curie temperature (T_{C}¹) by action of the external magnetic field (B1), the field strength of the external magnetic field (B1) being greater than the saturation field strength of the first layer (10; 100), so that the magnetization of the first layer (10; 100) is oriented by a second-order phase transition along the field direction of the external magnetic field; and
(D) the layer system (R, R') is subsequently cooled below the second Curie temperature (T_{C}²), the magnetization of the second layer (11; 101) being oriented antiparallel with respect to the magnetization of the first layer (10; 100) on account of antimagnetic coupling between the first and second layers (10; 100 and 11; 101).

2. Fabrication method according to Claim 1,
**characterized in that**
the net magnetization of the layer system (R; R') is set through the choice of the saturation flux, in particular of the layer cross section in each case of the first and second layers (10; 100 and 11; 101).

3. Fabrication method according to Claim 1 or 2,
**characterized in that**
the net magnetization of the layer system (R; R') is set to zero by the respectively identical net magnetization of the first layer (10; 100) and the second layer (11; 101).

4. Fabrication method according to Claim 1 or 2,
**characterized in that**
the net magnetization of the layer system (R; R') is set to be not equal to zero through selection of the second layer (11) such that the layer cross section thereof is smaller than that of the first layer (10; 100).

5. Fabrication method according to one of the preceding claims,
**characterized in that**
in step (D), upon passing through the second Curie temperature (T_{C}²), an external magnetic field (B2) is applied whose field direction is opposite to the magnetization direction of the first layer (10; 100).

6. Fabrication method according to one of Claims 1 to 5,
**characterized in that**
in step (A), a layer system (R') is provided which has a very thin intermediate coupling layer (102) between the first and second layers (100 and 101), and the antiferromagnetic coupling in step (D) is imparted by the intermediate coupling layer (102).

7. Fabrication method according to one of Claims 1 to 6,
**characterized in that**
the material of the first layer (10; 100) is chosen from the group comprising (Co, Fe, Mn)₈₀(Si, B)₂₀; (Co, Fe)₈₃(Si, B)₁₇; Tb₂₀Fe₄₀Co₄₀,
and the material of the second layer is chosen from the group comprising (Co, Fe, Mo)₇₃(Si, B)₂₇; (Ni, Fe)₇₈(Si, B, C)₂₂; Tb₂₀Fe₈₀.

8. Fabrication method according to Claim 7,
**characterized in that**
the material of the intermediate coupling layer (102) is chosen from the group comprising ruthenium, copper, gold.

9. MRAM memory cell,
**characterized in that**
it has a reference layer comprising a layer system (R; R'), which has a first layer (10; 100) of a material having a first Curie temperature (T_{C}¹) and a second layer (11; 101) of a material having a second Curie temperature (T_{C}²), which is significantly less than the first Curie temperature (T_{C}¹), and
the reference layer is fabricated by the method described in one of Claims 1 to 8.

## Revendications

1. Procédé de production d'une couche de référence pour des cellules de mémoire MRAM,
**caractérisé par** des stades suivants :
(A) on procure pour la couche de référence un système stratifié qui a une première couche (10, 100) pouvant être aimantée de façon permanente par un champ magnétique extérieur en un matériau ayant un premier point (T_{C}¹) de Curie et une deuxième couche (11, 101) pouvant être aimantée par couplage antiferromagnétique avec la première couche en un matériau ayant un deuxième point (T_{C}²) de Curie qui est nettement plus bas que le premier point (T_{C}¹) de Curie ;
(B) on produit un champ (B1) magnétique extérieur ;
(C) on refroidit le système (R, R') stratifié d'une température au-dessus du premier point (T_{C}¹) de Curie par l'action du champ (B1) magnétique extérieur jusqu'en dessous du premier point (T_{C}¹) de Curie, l'intensité du champ (B1) magnétique extérieur étant plus grande que l'intensité du champ de saturation de la première couche (10, 100) de sorte que l'aimantation de la première couche (10, 100) est orientée par une transition de phase de deuxième ordre le long de la direction du champ magnétique extérieur ; et
(D) on refroidit ensuite le système (R, R') stratifié en dessous du deuxième point (T_{C}²) de Curie, l'aimantation de la deuxième couche (11, 101) étant orientée en raison d'un couplage antimagnétique entre la première et la deuxième couches (10, 100 et 11, 101) antiparallèlement par rapport à l'aimantation de la première couche (10, 100).

2. Procédé de production suivant la revendication 1, **caractérisé en ce que** l'on règle l'aimantation nette du système (R, R') stratifié par le choix du flux de saturation, notamment de la section transversale de, respectivement, la première et deuxième couches (10, 100 et 11, 101).

3. Procédé de production suivant la revendication 1 ou 2, **caractérisé en ce que** l'on règle l'aimantation nette du système (R, R') stratifié à zéro par la même aimantation nette, respectivement, de la première couche (10, 100) et de la deuxième couche (11, 101).

4. Procédé de production suivant la revendication 1 ou 2, **caractérisé en ce que** l'on règle l'aimantation nette du système (R, R') stratifié à une valeur différente de zéro en choisissant la deuxième couche (11) de façon à ce que sa section transversale soit plus petite que celle de la première couche (10, 100).

5. Procédé de production suivant l'une des revendications précédentes, **caractérisé en ce qu'**au stade (D) on applique lors du passage par le deuxième point (T_{C}²) de Curie un champ (B2) magnétique extérieur dont le sens d'orientation du champ est opposé au sens d'aimantation de la première couche (10, 100).

6. Procédé de production suivant l'une des revendications 1 à 5, **caractérisé en ce qu'**au stade (A) on procure un système (R') stratifié qui a une très mince couche (102) de couplage intermédiaire entre la première et la deuxième couches (100 et 101) et **en ce que** l'on procure le couplage antiferromagnétique au stade (D) par la couche (102) intermédiaire de couplage.

7. Procédé de production suivant l'une des revendications 1 à 6, **caractérisé en ce que** le matériau de la première couche (10, 100) est choisi dans le groupe qui comporte (Co, Fe, Mn)₈₀(Si, B)₂₀ ; (Co, Fe)₈₃(Si, B)₁₇ ; Tb₂₀Fe₄₀Co₄₀ et **en ce que** le matériau de la deuxième couche est choisi dans le groupe qui comporte (Co, Fe, Mn)₇₃(Si, B)₂₇ ; (Ni, Fe)₇₈(Si, B, C)₂₂ ; Tb₂₀Fe₈₀.

8. Procédé de production suivant la revendication 7, **caractérisé en ce que** le matériau de la couche (102) intermédiaire de couplage est choisi dans le groupe qui comporte le ruthénium, le cuivre et l'or.

9. Cellule de mémoire MRAM, **caractérisée en ce qu'**elle a une couche de référence constituée d'un système (R, R') stratifié qui comporte une première couche (10, 100) d'un matériau ayant un premier point (T_{C}¹) de Curie et une deuxième couche (11, 101) en un matériau ayant un deuxième point (T_{C}²) de Curie qui est nettement plus bas que le premier point (T_{C}¹) de Curie et **en ce que** la couche de référence est produite par le procédé décrit dans l'une des revendications 1 à 8.
